**Europäisches Patentamt**

**European Patent Office**

**Office européen des brevets**

(19)

(11) Veröffentlichungsnummer: **0 222 281 B1**

# EUROPÄISCHE PATENTSCHRIFT

(12)

(45) Veröffentlichungstag der Patentschrift:
30.01.91 Patentblatt 91/05

(51) Int. Cl.$^5$: **G01R 33/38**

(21) Anmeldenummer: **86115160.3**

(22) Anmeldetag: **31.10.86**

(54) **Kernspintomographiegerät.**

(30) Priorität: **12.11.85 DE 3540080**

(43) Veröffentlichungstag der Anmeldung:
**20.05.87 Patentblatt 87/21**

(45) Bekanntmachung des Hinweises auf die
Patenterteilung:
**30.01.91 Patentblatt 91/05**

(84) Benannte Vertragsstaaten:
**DE FR GB NL**

(56) Entgegenhaltungen:
**US-A- 4 240 439
REVIEW OF SCIENTIFIC INSTRUMENTS,
Band 56, Nr. 1, Januar 1985, Seiten 131-135,
New York, US; D.I. HOULT et al.: "Shimming a
superconducting
nuclear-magnetic-resonance imaging magnet
with steel"**

(56) Entgegenhaltungen:
**NUCLEAR INSTRUMENTS AND METHODS,
Band 203, 1982, Seiten 81-85, North-Holland
Publishing Co., Amsterdam, NL; B. FEINBERG
et al.: "A method for improving the quality of
the magnetic field in a solenoid"
NUCLEAR INSTRUMENTS AND METHODS,
Band 140, 1977, Seiten 39-45, North-Holland
Publishing Co., Amsterdam, NL; U. CZOK et
al.: "Surface coils to improve the
homogeneity of a given magnet"
PATENT ABSTRACTS OF JAPAN, Band 8, Nr.
163 (P-290)[1600], 27. Juli 1984 & JP-A-59-60
346**

(73) Patentinhaber: **Siemens Aktiengesellschaft
Wittelsbacherplatz 2
D-8000 München 2 (DE)**

(72) Erfinder: **Frese, Georg, Dipl.-Phys.
Friedrich-Bauer-Strasse 7
D-8520 Erlangen (DE)**
Erfinder: **Ladwein, Karl-Georg, Dipl.-Phys.
Heinrich-Hertz-Strasse 13
D-8520 Erlangen (DE)**

Go

## Beschreibung

Die Erfindung betrifft ein Kernspintomographiegerät zur Untersuchung eines Objektes mit Hilfe der kernmagnetischen Resonanz, mit Spulen zum Anlegen von magnetischen Grund- und Gradientenfeldern an das Untersuchungsobjekt, mit einer Hochfrequenzeinrichtung, die das Untersuchungsobjekt mit Hochfrequenzpulsen bestrahlt und die vom Untersuchungsobjekt abgestrahlten Kernresonanzsignale erfaßt, sowie mit Stäben aus ferromagnetischem Material zur Homogenisierung der Magnetfelder.

Ein Gerät dieser Art ist aus dem Artikel "SHIMMING A SUPER-CONDUCTING NUCLEAR MAGNETIC RESONANCE IMAGING MAGNET WITH STEEL", Review of Scientific Instruments, Band 56, Nr. 1, Januar 1985, Seiten 131-135 bekannt. Für eine gute Bildqualität ist es erforderlich, die auftretenden Grundfeldstörungen zu korrigieren. Hierzu sind bei dem bekannten Gerät im Inneren des Grundfeldmagneten Stahlstäbe vorgesehen, die derart angebracht sind, daß durch eine geeignete Anordnung, Anzahl und Länge der Stäbe das magnetische Grundfeld homogenisiert ist. Diese Stahlstäbe weisen über die Längsrichtung des Untersuchungsraums einen gleichförmigen Querschnitt und eine homogene Materialverteilung auf. Da somit keine Variation der Shim-Wirkung in Längsrichtung möglich ist, bleibt die Shim-Wirkung unvollkommen.

Aus der US-PS 3 564 398 ist es bekannt, Grundfeldinhomogenitäten mit einer Vielzahl von stromdurchflossenen Korrekturspulen, sogenannten Shim-Spulen, zu korrigieren.

Der Erfindung liegt die Aufgabe zugrunde, für eine Korrektur von Grundfeldstörungen, also für die Homogenisierung des Grundfeldes, Mittel vorzusehen, die eine verbesserte Grundfeldhomogenität ermöglichen.

Diese Aufgabe wird erfindungsgemäß dadurch gelöst, daß die Stäbe über ihre Länge Bereiche mit unterschiedlichen magnetischen Eigenschaften aufweisen.

In Bereichen der Stäbe mit ferromagnetischen Eigenschaften wird durch das Grundfeld eine Magnetisierung des Stabmaterials bewirkt, die wiederum einen korrigierenden Einfluß auf das Grundfeld zur Folge hat. Durch eine geeignete Kombination der so beschaffenen Stäbe, die auch unterschiedliche Längen und Durchmesser haben können, ist eine gute Homogenisierung erreichbar.

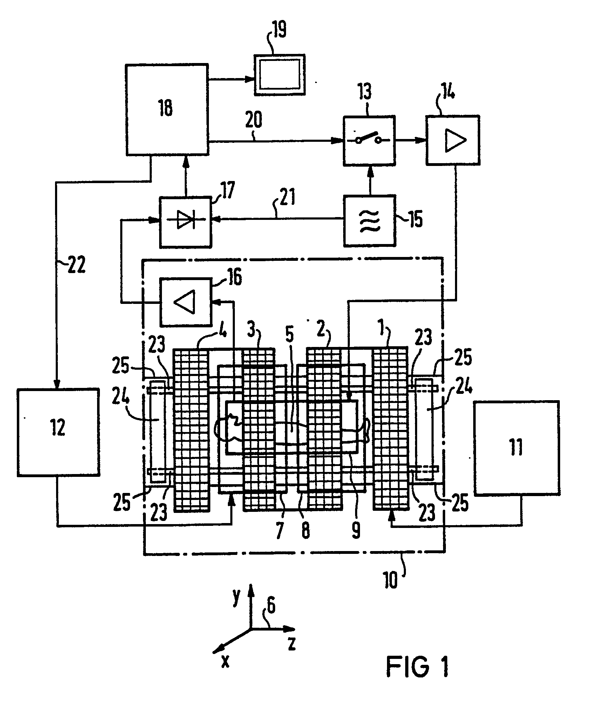

Zur Homogenisierung in x-, y- und z-Richtung (siehe Figur 1) können die Stäbe an den Längsseiten des Untersuchungsraumes parallel zu der Zylinderlängsrichtung und/oder sternförmig an einer der Stirnwände des Gerätes angebracht sein. Werden an der Außenseite der Spulen magnetische Rückführungen entsprechend der deutschen Patentanmeldung P 33 33 755.1 angeordnet, so ist eine Kompensation der durch diese magnetischen Rückführungen erzeugten Feldstörungen dadurch möglich, daß die Stäbe an der Mantelfläche eines den Untersuchungsraum umgebenden Kunststoffrohres angebracht werden.

Die Erfindung ist nachfolgend anhand der Zeichnung näher erläutert. Es zeigen:
Fig. 1 ein Kernspintomographiegerät zur Erläuterung des Erfindungsgedankens,
Fig. 2 ein Kunststoffrohr mit Spannringen zur Befestigung der Stäbe, und
Fig. 3 eine Ausführungsform des Stabes.

In der Figur 1 sind mit 1 und 2 sowie 3 und 4 Spulen gekennzeichnet, mit welchen ein magnetisches Grundfeld $B_0$ erzeugt wird, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur 1 sind der Übersichtlichkeit halber nur Gradientenspulen 7 und 8 gezeichnet, die zusammen mit einem Paar gegenüberliegender, gleichartiger Gradientenspulen zur Erzeugung eines x-Gradienten dienen. Die gleichartigen, nicht gezeichneten y-Gradientenspulen liegen parallel zum Körper 5 oberhalb sowie unterhalb von ihm; die für das z-Gradientenfeld quer zu seiner Längsachse am Kopf- und am Fußende. Die Anordnung enthält außerdem noch eine zur Anregung der Kernresonanz und Aufnahme der Kernresonanzsignale dienende Antenne 9.

Die von einer strichpunktierten Linie 10 umgrenzten Komponenten 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die sowohl zur Anregung als auch zur Aufnahme des Signales dienende Antenne 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozeßrechner 18, von dem zur Ausgabe der Abbildung ein Bildschirmgerät 19 versorgt wird. Zur Steuerung der Anordnung sind außerdem noch Verbindungen 20, 21 und 22 zwischen dem Rechner 18 und dem Modulator 13 sowie dem Oszillator 15 und dem Gleichrichter 17 sowie dem Rechner 18 und der Gradientenstromversorgung 12 vorgesehen.

Die erfindungsgemäßen Stäbe 23 sind parallel zur Zylinderlängsachse (z-Richtung) ausgerichtet und werden durch senkrecht zur z-Achse angebrachte Spannringe 24 mit Löchern in ihrer Lage fixiert. Der Übersichtlichkeit halber sind in Figur 1 nur zwei dieser Spannringe 24 und nur zwei eingesetzte Stäbe 23 eingezeichnet. Die Spannringe 24 sind auf dem Mantel eines den Untersuchungsraum umgebenden Kunststoffrohres 25 angebracht.

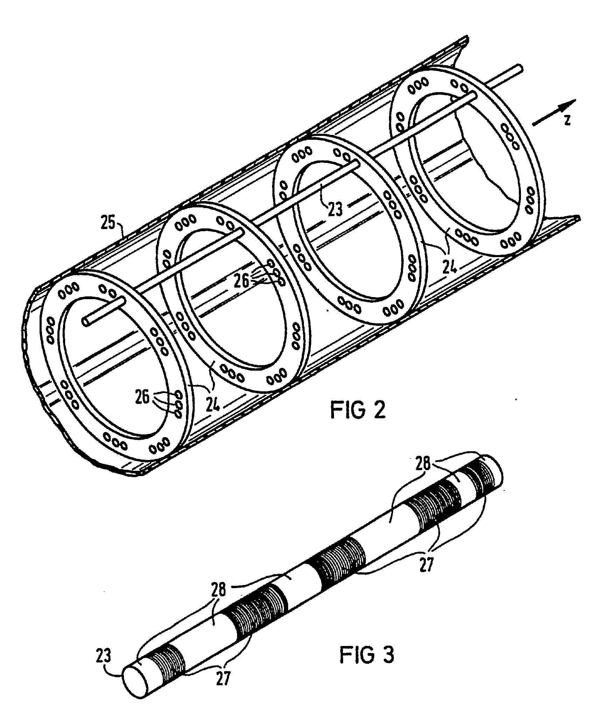

Die Figur 2 zeigt schematisch die räumliche Ansicht des Kunststoffrohres 25, in dem zur Halterung der Stäbe 23 die Spannringe 24 auf dem Innenmantel des Rohres 25 in Ebenen senkrecht zur z-Richtung befestigt und mit einer Anordnung von Löchern 26 versehen sind. Die spezielle Anordnung der Löcher 26, ihrer Durchmesser und Abstände, sowie der Querschnitt, Aufbau und die Länge der Stäbe 23 werden so gewählt, daß eine optimale Homogenisierung des Grundfeldes erreicht wird.

Alternativ können die Spannringe 24 auch auf dem Außenmantel des Kunststoffrohres 25 angebracht sein. Ebenso ist eine Anordnung der Stäbe auf dem Außenmantel der Grundfeld-Magnetspule möglich.

Die Figur 3 zeigt eine mögliche Ausführungsform eines Stabes 23. In Längsrichtung betrachtet wechseln sich Bereiche mit ferromagnetischen Eigenschaften 27 und antimagnetischen Eigenschaften 28 miteinander ab. Durch geeignete Wahl der Abstände und Längen dieser Bereiche läßt sich das magnetische Grundfeld homogenisieren. Alternativ kann der Stab 23 realisiert werden durch ein unmagnetisches Rohr, welches nacheinander mit Materialien unterschiedlicher magnetischer Eigenschaften aufgefüllt wird. Die Bereiche unterschiedlicher magnetischer Eigenschaften müssen nicht notwendigerweise streng getrennt sein, sondern können auch fließend ineinander übergehen. Weitere Möglichkeiten ergeben sich beispielsweise durch Verbinden von kurzen Teilstäben unterschiedlicher magnetischer Eigenschaften über unmagnetische Gewindestücke zu einem Gesamtstab oder durch Positionieren einzelner Teilstäbe auf einem langem durchgehenden unmagnetischen Gewindestab, wobei die Teilstäbe durchgehende Innengewinde aufweisen.

## Ansprüche

1. Kernspintomographiegerät zur Untersuchung eines Objektes (5) mit Hilfe der kernmagnetischen Resonanz, mit Spulen (1, 2, 3, 4, 7, 8, 9) zum Anlegen von magnetischen Grund- und Gradientenfeldern an das Untersuchungsobjekt (5), mit einer Hochfrequenzeinrichtung (9, 13, 14, 15, 16, 17), die das Untersuchungsobjekt (5) mit Hochfrequenzpulsen bestrahlt und die vom Untersuchungsobjekt (5) abgestrahlten Kernresonanzsignale erfaßt, sowie mit Stäben (23) aus ferromagnetischem Material zur Homogenisierung der Magnetfelder, **dadurch gekennzeichnet,** daß zur Korrektur von Grundfeldinhomogenitäten die Stäbe (23) über ihre Länge Bereiche (27, 28) mit unterschiedlichen magnetischen Eigenschaften aufweisen.

2. Kernspintomographiegerät nach Anspruch 1,
**dadurch gekennzeichnet,** daß die Stäbe (23) durch Löcher (26) in Spannringen (24) durchgeführt sind und durch diese gehalten werden.

3. Kernspintomographiegerät nach Anspruch 2, **dadurch gekennzeichnet,** daß die Spannringe (24) an einem Zylinder (25) innerhalb der Grundfeldspule (1, 2, 3, 4) befestigt sind.

4. Kernspintomographiegerät nach Anspruch 2, **dadurch gekennzeichnet,** daß die Spannringe (24) auf dem Außenmantel der Grundfeldspule (1, 2, 3, 4) befestigt sind.

5. Kernspintomographiegerät nach einem der Ansprüche 1 bis 4, **dadurch gekennzeichnet,** daß die Stäbe (23) in äquidistanten, azimutalen Abständen einzeln oder in Gruppen angeordnet sind.

6. Kernspintomographiegerät nach einem der Ansprüche 1 bis 5, **dadurch gekennzeichnet,** daß die Stäbe (23) unterschiedliche Durchmesser aufweisen.

7. Kernspintomographiegerät nach einem der Ansprüche 1 bis 6, **dadurch gekennzeichnet,** daß die Stäbe (23) durch unmagnetische Rohre, die mit einem magnetischen Material gefüllt sind, gebildet werden.

8. Kernspintomographiegerät nach einem der Ansprüche 1 bis 7, **dadurch gekennzeichnet,** daß die Bereiche (27, 28) mit unterschiedlichen magnetischen Eigenschaften fließend ineinander übergehen.

9. Kernspintomographiegerät nach einem der Ansprüche 1 bis 7, **dadurch gekennzeichnet,** daß die Stäbe (23) durch Teilstäbe mit unterschiedlichen magnetischen Eigenschaften aufgebaut sind.

10. Kernspintomographiegerät nach einem der Ansprüche 1 bis 6, **dadurch gekennzeichnet,** daß die Stäbe (23) durch lange durchgehende Gewindestücke gebildet werden, auf denen Teilstäbe mit durchgehenden Innengewinden durch Drehen um die Gewindestücke positioniert werden können.

## Claims

1. Nuclear spin tomography device for examining an object (5) with the aid of nuclear magnetic resonance, having coils (1, 2, 3, 4, 7, 8, 9) for applying fundamental and gradient magnetic fields to the object under examination (5), having a high frequency means (9, 13, 14, 15, 16, 17) which irradiates the object under examination (5) with high frequency pulses and picks up the nuclear resonance signals radiated from the object under examination (5), and having rods (23) of ferromagnetic material for homogenising the magnetic fields, characterised in that in order to correct basic field inhomogeneities the rods (23) have over their length regions (27, 28) with different magnetic properties.

2. Nuclear spin tomography device according to claim 1, characterised in that the rods (23) are guided through holes (26) in clamping rings (24) and are held by them.

3. Nuclear spin tomography device according to claim 2, characterised in that the clamping rings (24) are secured on a cylinder (25) inside the fundamental field coil (1, 2, 3, 4).

4. Nuclear spin tomography device according to claim 2, characterised in that the clamping rings (24) are secured on the outer casing of the fundamental field coil (1, 2, 3, 4).

5. Nuclear spin tomography device according to one of claims 1 to 4, characterised in that the rods (23) are arranged individually or in groups at equidistant azimuthal spacings.

6. Nuclear spin tomography device according to one of claims 1 to 5, characterised in that the rods (23) have different diameters.

7. Nuclear spin tomography device according to one of claims 1 to 6, characterised in that the rods (23) are formed by non-magnetic tubes which are filled with a magnetic material.

8. Nuclear spin tomography device according to one of claims 1 to 7, characterised in that the regions (27, 28) with different magnetic properties merge into one another.

9. Nuclear spin tomography device according to one of claims 1 to 7, characterised in that the rods (23) are formed by rod portions with different magnetic properties.

10. Nuclear spin tomography device according to one of claims 1 to 6, characterised in that the rods (23) are formed by long threaded full-length pieces on which rod portions with inner full-length threads can be positioned by rotation about the threaded pieces.

## Revendications

1. Appareil de tomographie à spin nucléaire pour l'analyse d'un objet (5), à l'aide de la résonance magnétique nucléaire, comprenant des bobines (1, 2, 3, 4, 7, 8, 9) pour appliquer à l'objet à analyser (5) des champs magnétiques de base et irrotationnels, un dispositif haute fréquence (9, 13, 14, 15, 16, 17 qui envoie, sur l'objet à analyser (5), des impulsions haute fréquence et qui détecte des signaux de résonance nucléaire émis par l'objet à analyser (5), ainsi que des barreaux (23) en matériau ferromagnétique destinés à homogénéiser les champs magnétiques, caractérisé en ce que, pour corriger des défauts d'homogénéité du champ de base, les barreaux (23) comportent, sur leur longueur, des parties (27, 28) ayant des propriétés magnétiques différentes.

2. Appareil de tomographie à spin nucléaire suivant la revendication 1, caractérisé en ce que les barreaux (23) passent dans des trous (26) ménagés dans des anneaux de blocage (24) et sont maintenus par ceux-ci.

3. Appareil de tomographie à spin nucléaire suivant la revendication 2, caractérisé en ce que les anneaux de blocage (24) sont fixés à un cylindre (25), à l'intérieur de la bobine du champ de base (1, 2, 3, 4).

4. Appareil de tomographie à spin nucléaire suivant la revendication 2, caractérisé en ce que les anneaux de blocage (24) sont fixés sur la surface latérale extérieure de la bobine du champ de base (1, 2, 3, 4).

5. Appareil de tomographie à spin nucléaire suivant l'une des revendications 1 à 4, caractérisé en ce que les barreaux (23) sont disposés individuellement ou par groupes, à des intervalles azimutaux et équidistants.

6. Appareil de tomographie à spin nucléaire suivant l'une des revendications 1 à 5, caractérisé en ce que les barreaux (23) ont des diamètres différents.

7. Appareil de tomographie à spin nucléaire suivant l'une des revendications 1 à 6, caractérisé en ce que les barreaux (23) sont formés de tubes amagnétiques qui sont garnis d'un matériau magnétique.

8. Appareil de tomographie à spin nucléaire suivant l'une des revendications 1 à 7, caractérisé en ce qu'on passe insensiblement d'une partie (27) à une partie (28) à propriétés magnétiques différentes.

9. Appareil de tomographie à spin nucléaire suivant l'une des revendications 1 à 7, caractérisé en ce que les barreaux (23) sont constitués de barreaux partiels ayant des propriétés magnétiques différentes.

10. Appareil de tomographie à spin nucléaire suivant l'une des revendications 1 à 6, caractérisé en ce que les barreaux (23) sont formés de longues pièces filetées continues, sur lesquelles des barreaux partiels à taraudage continu peuvent être mis en position par rotation autour les pièces filetées.

FIG 1

FIG 2

FIG 3